# EUROPEAN PATENT APPLICATION

(11) **EP 4 439 960 A1**
(43) Date of publication of application: **02.10.2024**
(21) Application number: 21964834.2
(22) Date of filing: 22.11.2021
(51) Int. Cl.: H02M 7/48, H02M 7/49

(54) **POWER CONVERSION SYSTEM**

(71) Applicant: MITSUBISHI ELECTRIC CORPORATION, Chiyoda-ku Tokyo 100-8310 (JP)
(72) Inventor: SADAKUNI, Hitoshi, Tokyo 100-8310 (JP); ONISHI, Ryota, Tokyo 100-8310 (JP); TEMMA, Koji, Tokyo 100-8310 (JP)
(74) Representative: Witte, Weller & Partner Patentanwälte mbB
(86) International application number: PCT/JP2021/042772
(87) International publication number: WO 2023/089819

(57) **Abstract**

A power conversion system (2) includes a plurality of submodules (5A, 5B, 6A, 6B) for respective arms, the plurality of submodules being provided between respective phases of first and second AC power systems and DC buses (14P, 14N), and cascade-connected to each other. Each of the plurality of submodules serves as a unit converter that converts between AC power and DC power. The power conversion system further includes reactors (7A, 7B, 8A, 8B) connected between the plurality of submodules for respective arms and portions for connection to the AC power systems, and at least one housing chamber (40). The plurality of submodules for respective arms and the DC buses are housed in the at least one housing chamber, and the reactors are arranged outside the housing chamber.

## Description

### TECHNICAL FIELD

The present disclosure relates to a power conversion system.

### BACKGROUND ART

A power conversion system that converts an alternating current (AC) into a direct current (DC) and the direct current into an alternating current in sequence is used to interchange electric power mainly between two independent asynchronous AC power systems. This type of power conversion system is also called "BTB (back to back)" because a converter and an inverter are arranged back to back to each other (refer to, for example, Japanese National Patent Publication No. 2009-507462 (PTL 1)). In Japan, the BTB is used between an AC power system having a frequency of 50 Hz and an AC power system having a frequency of 60 Hz.

A modular multilevel converter (MMC) may be used as each of the converter and the inverter that form the above-described BTB. The MMC includes arms provided for respective phases of AC power systems, and each of the arms is formed by cascade-connecting a plurality of submodules. Each of the submodules is a unit converter including a plurality of semiconductor switching elements and one or more capacitors. Furthermore, each of the arms is provided with a reactor to suppress a circulating current and a fault current.

### CITATION LIST

### PATENT LITERATURE

PTL 1: Japanese National Patent Publication No. 2009-507462

### SUMMARY OF INVENTION

### TECHNICAL PROBLEM

Since the power conversion system as described above is a high-voltage and large-capacity system, the installation space is required and the maintenance cost is high. Therefore, the important thing is how to arrange each of the above-described submodules and each of the above-described reactors in consideration of the maintainability of the power conversion system.

The present disclosure has been made in view of the above-described problem, and one object thereof is to provide a power conversion system excellent in maintainability.

### SOLUTION TO PROBLEM

A power conversion system that performs power conversion between a first AC power system and a second AC power system includes: a positive-side DC bus and a negative-side DC bus; a plurality of first upper arms connected between respective phases of the first AC power system and the positive-side DC bus; a plurality of first lower arms connected between the respective phases of the first AC power system and the negative-side DC bus; a plurality of second upper arms connected between respective phases of the second AC power system and the positive-side DC bus; and a plurality of second lower arms connected between the respective phases of the second AC power system and the negative-side DC bus. Each of the plurality of first upper arms, the plurality of first lower arms, the plurality of second upper arms, and the plurality of second lower arms includes: a plurality of submodules cascade-connected to each other, each of the plurality of submodules serving as a unit converter that converts between AC power and DC power; and a reactor connected in series to the plurality of submodules. In each of the plurality of first upper arms and each of the plurality of second upper arms, the plurality of submodules are connected between the reactor and the positive-side DC bus. In each of the plurality of first lower arms and each of the plurality of second lower arms, the plurality of submodules are connected between the reactor and the negative-side DC bus. The power conversion system further includes at least one housing chamber that houses the plurality of submodules of each of the plurality of first upper arms, the plurality of submodules of each of the plurality of first lower arms, the plurality of submodules of each of the plurality of second upper arms, the plurality of submodules of each of the plurality of second lower arms, the positive-side DC bus, and the negative-side DC bus. The reactor of each of the plurality of first upper arms, the reactor of each of the plurality of first lower arms, the reactor of each of the plurality of second upper arms, and the reactor of each of the plurality of second lower arms are provided outside the at least one housing chamber.

### ADVANTAGEOUS EFFECTS OF INVENTION

According to the embodiment above, the plurality of submodules that form each of the upper arms and the plurality of submodules that form each of the lower arms are housed in the at least one housing chamber, and the reactors are arranged outside the at least one housing chamber. Therefore, a power conversion system excellent in maintainability can be provided.

### BRIEF DESCRIPTION OF DRAWINGS

Fig. 1 is a block diagram showing an electrical configuration of a power conversion system according to the present embodiment.
Fig. 2 is a circuit diagram showing a configuration example of a submodule that forms a power converter.
Fig. 3 is a perspective view showing a specific arrangement example of a plurality of submodules that form each arm.
Fig. 4 is a plan view showing a configuration of a stage ST1.
Fig. 5 is a plan view showing a specific arrangement example of a power conversion system 2 shown in Fig. 1.
Fig. 6 is a side view of a portion of a reactor 7UA of a U-phase upper arm 3UA shown in Fig. 5.
Fig. 7 is a side view of a portion of a plurality of submodules 20 (SUA) and a positive-side DC bus 14P shown in Fig. 5.

### DESCRIPTION OF EMBODIMENTS

An embodiment will be described in detail below with reference to the drawings. In the description below, the Z direction indicates the vertical direction, and the X direction and the Y direction indicate the directions in a horizontal plane. The X direction and the Y direction do not necessarily need to be orthogonal to each other, and may cross each other at an angle close to 90 degrees. In addition, in the description below, the same or corresponding portions are denoted by the same reference characters and description thereof will not be repeated.

### First Embodiment

### [Overall Configuration of Power Conversion System]

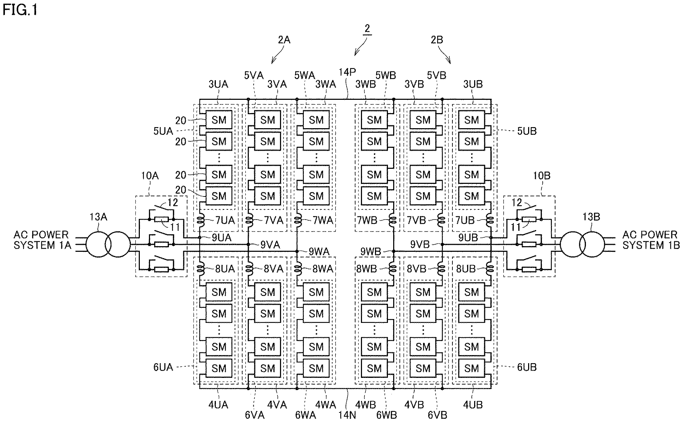

An electrical connection relationship of a power conversion system will be first described. Fig. 1 is a block diagram showing an electrical configuration of a power conversion system according to the present embodiment.

Referring to Fig. 1, a power conversion system 2 performs power conversion between a first AC power system 1A and a second AC power system 1B. Power conversion system 2 includes a first power conversion device 2A that performs power conversion between AC power system 1A and DC buses 14P and 14N, and a second power conversion device 2B that performs power conversion between AC power system 1B and DC buses 14P and 14N.

The components that form power conversion system 2 will be described in more detail below. In the description below, the configuration of power conversion device 2A on the AC power system 1A side is the same as the configuration of power conversion device 2B on the power conversion device 2B side. Therefore, the configuration of power conversion device 2A will be mainly described below. The reference characters of the components on the power conversion device 2B side are indicated by replacing the letter "A" at the end of the reference characters of the components on the power conversion device 2A side with "B".

### [Electrical Configuration of Power Converter]

Referring to Fig. 1, power conversion device 2A is formed by a modular multilevel converter (MMC) including a plurality of submodules (SMs) 20 cascade-connected to each other. "Submodule" is also called "converter cell" or "unit converter".

Power conversion device 2A includes a U-phase upper arm 3UA and a U-phase lower arm 4UA that correspond to a U phase of AC power system 1A, a V-phase upper arm 3VA and a V-phase lower arm 4VA that correspond to a V phase of AC power system 1A, and a W-phase upper arm 3WA and a W-phase lower arm 3WB that correspond to a W phase of AC power system 1A. U-phase upper arm 3UA includes a plurality of submodules 20 (SUA) and a reactor 7UA that are connected in series between positive-side DC bus 14P and a U-phase AC terminal 9UA. U-phase lower arm 4UA includes a plurality of submodules 20 (6UA) and a reactor 8VB that are connected in series between negative-side DC bus 14N and U-phase AC terminal 9UA.

The same applies as well to the V phase and the W phase. Specifically, V-phase upper arm 3VA includes a plurality of submodules 20 (5VA) and a reactor 7VA that are connected in series between positive-side DC bus 14P and a V-phase AC terminal 9VA. V-phase lower arm 4VA includes a plurality of submodules 20 (6VA) and a reactor 8VB that are connected in series between negative-side DC bus 14N and V-phase AC terminal 9VA. W-phase upper arm 3WA includes a plurality of submodules 20 (5WA) and a reactor 7WA that are connected in series between positive-side DC bus 14P and a W-phase AC terminal 9WA. W-phase lower arm 4WA includes a plurality of submodules 20 (6WA) and a reactor 8VB that are connected in series between negative-side DC bus 14N and W-phase AC terminal 9WA. When the upper arms and the lower arms are collectively referred to, or any one of the phases is indicated, they are described as "upper arm 3A" and "lower arm 4A". When the plurality of submodules of each of the upper arms and the plurality of submodules 20 of each of the lower arms are collectively referred to, or any one of them is indicated, they are described as "plurality of submodules 5A" and "plurality of submodules 6A". When the reactors of each of the upper arms and the reactors of each of the lower arms are collectively referred to, or any one of them is indicated, they are described as "reactor 7A" and "reactor 8A".

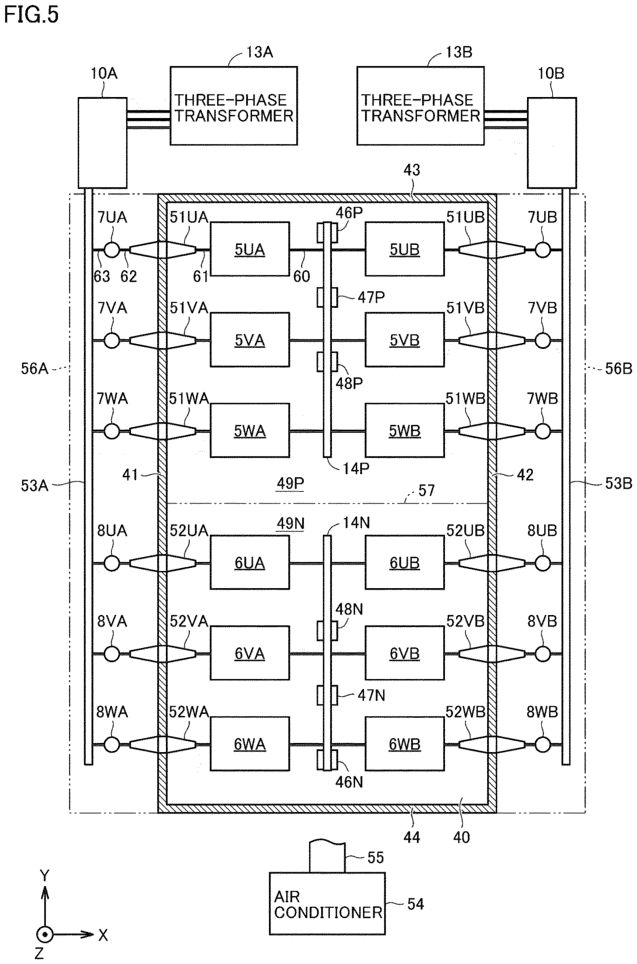

Reactor 7A is connected between AC terminal 9A and the plurality of submodules 5A, and reactor 8A is connected between reactor 8A and the plurality of submodules 6A. That is, reactors 7A and 8A are arranged in proximity to AC terminal 9A (i.e., at a distance from positive-side DC bus 14P or negative-side DC bus 14N). This is because the maintainability of power conversion system 2 is taken into consideration, which will be described in detail below with reference to Fig. 5.

Power conversion device 2A further includes a transformer 13A and a resistor for initial charging 10A. Transformer 13A is connected between AC power system 1A and AC terminals 9UA, 9VA and 9WA (described as "AC terminal 9A" when they are collectively referred to). Instead of using transformer 13A shown in Fig. 1, AC power system 1A and power conversion device 2A may be connected via an interconnection reactor.

Resistor for initial charging 10A includes resistors 11 connected in series to lines of the U phase, the V phase and the W phase of AC power system 1A, respectively, and switches 12 connected in parallel to the resistors. At startup, each of switches 12 is brought into an open state, thereby suppressing a charging current flowing through submodules 20. In steady-state operation, each of switches 12 is brought into a closed state, thereby bypassing resistors 11.

Resistor for initial charging 10A may be provided on the primary side (i.e., on the AC power system 1A side) of transformer 13A, or may be provided on the secondary side (i.e., on the AC terminal 9A side) of transformer 13A. When resistor for initial charging 10A is provided on the primary side of transformer 13A, an inrush current flowing from AC power system 1A to transformer 13A can be suppressed.

### [Configuration Example of Submodule]

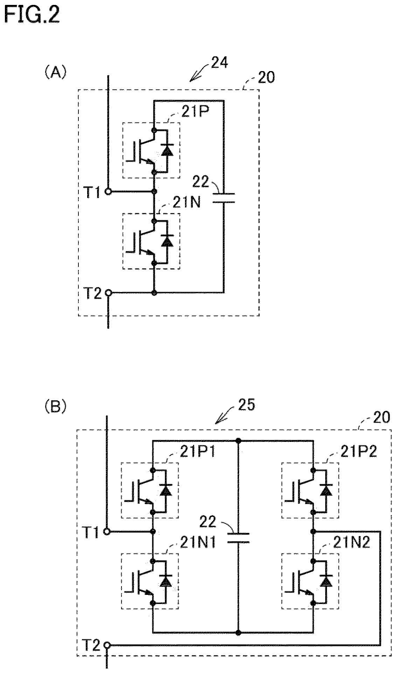

Fig. 2 is a circuit diagram showing a configuration example of the submodule that forms the power converter.

Submodule 20 shown in Fig. 2(A) has a circuit configuration called "half-bridge configuration". This submodule 20 includes a series unit formed by connecting two switching elements 21P and 21N in series, a power storage element 22, and input/output terminals T1 and T2. The series unit of switching elements 21P and 21N, and power storage element 22 are connected in parallel. Both terminals of switching element 21N are connected to input/output terminals T1 and T2, respectively. A half-bridge circuit is formed by switching elements 21P and 21N.

In response to the switching operation by switching elements 21P and 21N, submodule 20 outputs a voltage of power storage element 22 or a zero voltage to between input/output terminals T1 and T2. When switching element 21P is turned on and switching element 21N is turned off, the voltage of power storage element 22 is output from submodule 20. When switching element 21P is turned off and switching element 21N is turned on, submodule 20 outputs the zero voltage.

Submodule 20 shown in Fig. 2(B) has a circuit configuration called "full-bridge configuration". This submodule 20 includes a first series unit formed by connecting two switching elements 21P1 and 21N1 in series, a second series unit formed by connecting two switching elements 21P2 and 21N2 in series, power storage element 22, and input/output terminals T1 and T2. The first series unit, the second series unit and power storage element 22 are connected in parallel. A midpoint of switching element 21P1 and switching element 21N1 is connected to input/output terminal T1. Similarly, a midpoint of switching element 21P2 and switching element 21N2 is connected to input/output terminal T2. A full-bridge circuit 25 is formed by switching elements 21P1, 21N1, 21P2, and 21N2.

In response to the switching operation by switching elements 21P1, 21N1, 21P2, and 21N2, submodule 20 outputs a voltage of power storage element 22, a voltage having a sign inverted from a sign of the voltage of power storage element 22, or a zero voltage to between input/output terminals T1 and T2.

In Figs. 2(A) and 2(B), each of switching elements 21P, 21N, 21P1, 21N1, 21P2, and 21N2 is, for example, formed by connecting a freewheeling diode (FWD) in antiparallel to a self-extinguishing-type semiconductor switching element such as an insulated gate bipolar transistor (IGBT) or a gate commutated turn-off (GCT) thyristor.

In Figs. 2(A) and 2(B), a capacitor such as a film capacitor is mainly used as power storage element 22. In the following description, power storage element 22 may be referred to as "capacitor".

In each of Figs. 2(A) and 2(B), in submodule 20 arranged in upper arm 3A, 3B, input/output terminal T1 is connected to input/output terminal T2 of adjacent submodule 20 or positive-side DC bus 14P, and input/output terminal T2 is connected to input/output terminal T1 of adjacent submodule 20 or AC terminal 9A, 9B. Similarly, in submodule 20 arranged in lower arm 4A, 4B, input/output terminal T1 is connected to input/output terminal T2 of adj acent submodule 20 or AC terminal 9A, 9B, and input/output terminal T2 is connected to input/output terminal T1 of adjacent submodule 20 or negative-side DC bus 14N.

### [Specific Configuration Example of Plurality of Submodules]

Next, a specific arrangement example of the plurality of submodules 20 that form each arm will be described. As described below, submodules 20 are housed in a plurality of insulating containers stacked like a tower.

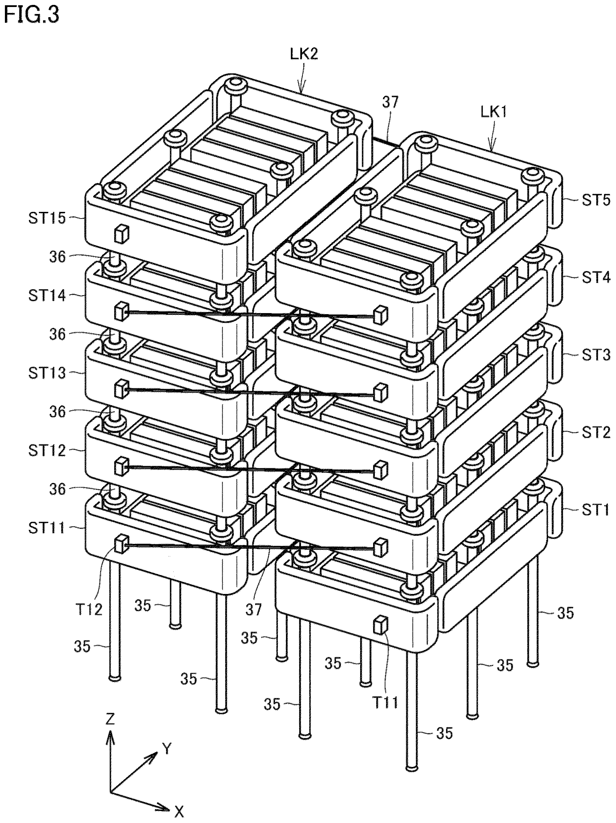

Fig. 3 is a perspective view showing a specific arrangement example of the plurality of submodules that form each arm. Although an arrangement example of the plurality of submodules 20 (SUA) that form U-phase upper arm 3UA will be described below, the same applies as well to the other arms.

Referring to Fig. 3, U-phase upper arm 3UA includes Q (where Q is an integer equal to or more than 2 and Q=2 in Fig. 3) racks LK1 and LK2. Racks LK1 and LK2 are arranged adjacent to each other in the X direction in Fig. 3.

Rack LK1 includes N (where N is an integer equal to or more than 2 and N=5 in Fig. 3) stages ST1 to ST5. Stages ST1 to ST5 are sequentially arranged in the Z direction (height direction) in Fig. 3 and are arranged to be parallel to each other. First stage ST1 is supported on a floor by six pillars 35. Stages ST2 to ST5 are supported on stages ST1 to ST4 by six pillars 36, respectively.

Rack LK2 includes N (where N is an integer equal to or more than 2 and N=5 in Fig. 3) stages ST11 to ST15. Stages ST11 to ST15 are sequentially arranged in the Z direction (height direction) in Fig. 3 and are arranged to be parallel to each other. First stage ST11 is supported on a floor by six pillars 35. Stages ST12 to ST15 are supported on stages ST11 to ST14 by six pillars 36, respectively. Stages ST11 to ST15 of rack LK2 are arranged at the same height as stages ST1 to ST5 of rack LK1, respectively.

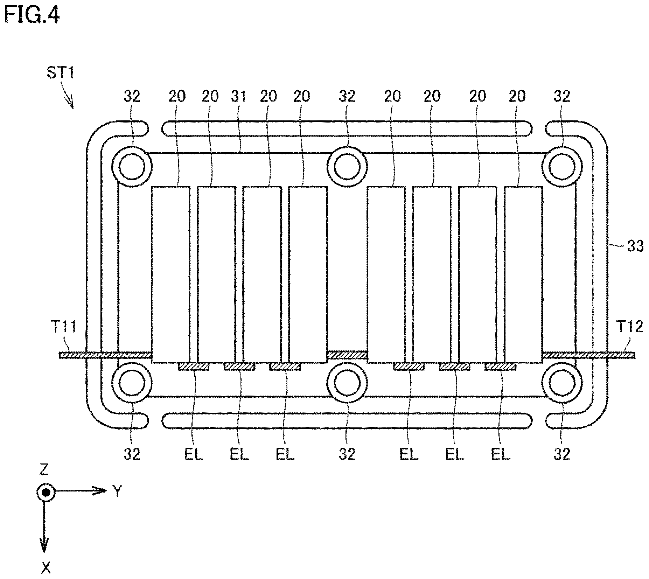

Fig. 4 is a plan view showing a configuration of stage ST1. In Fig. 4, stage ST1 includes a substrate 31 having a rectangular shape, six insulators 32, an insulating shield 33, a positive-side terminal T11, and a negative-side terminal T12. A shorter side of substrate 31 faces the X direction in Fig. 4 and a longer side thereof faces the Y direction in Fig. 4. Holes (not shown) are provided at six locations in a peripheral edge portion of substrate 31, and six insulators 32 are fitted into the six holes, respectively, and central portions of insulators 32 are fixed to substrate 31.

A hole into which pillar 35 or 36 is fitted is provided in each of an upper end portion and a lower end portion of each insulator 32. The perimeter of substrate 31 is covered with insulating shield 33. Insulating shield 33 is divided into four portions corresponding to the four sides of substrate 31, and each portion is fixed to substrate 31 by a fixing member (not shown).

M (where M is an integer equal to or more than 2 and M=8 in Fig. 4) submodules 20, a positive-side terminal T11 (first terminal) and a negative-side terminal T12 (second terminal) are mounted on a surface of substrate 31. Positive-side terminal T11, eight submodules 20 and negative-side terminal T12 are arranged in the Y direction in Fig. 4. Positive-side terminal T11 passes through insulating shield 33 and protrudes to the front side of stage ST1. Negative-side terminal T12 passes through insulating shield 33 and protrudes to the rear side of stage ST1. Eight submodules 20 are cascade-connected between terminals T11 and T12. Input/output terminals T1 and T2 of adjacent submodules 20 are connected to each other by a metal plate EL. Each of the other stages ST2 to ST5 of rack LK1 has the same configuration as the configuration of stage ST1.

In each of stages ST11 to ST15 of rack LK2, positive-side terminal T11, eight submodules 20 and negative-side terminal T12 are arranged in the direction opposite to the Y direction in Fig. 4. Positive-side terminal T11 passes through insulating shield 33 and protrudes to the rear side of stage ST11. Negative-side terminal T12 passes through insulating shield 33 and protrudes to the front side of stage ST11. Eight submodules 20 are cascade-connected between terminals T11 and T12.

Submodules 20 are connected in series. In the case of Fig. 3, terminal T11 of stage ST1 is a terminal on the highest potential side. Terminal T12 of stage ST1 and terminal T11 of stage ST11 are connected by a wire 37. Terminal T12 of stage ST1 1 and terminal T11 of stage ST2 are connected by wire 37. Terminal T12 of stage ST2 and terminal T11 of stage ST12 are connected by wire 37. Stages ST12, ST3, ST13, ST4, ST14, ST5, ST5, and ST15 are spirally connected in this order. Terminal T12 of stage ST15 is a terminal on the lowest potential side.

### [Planar Arrangement Example of Power Conversion System]

An actual arrangement example of power conversion system 2 shown in Fig. 1 will be described below with reference to Figs. 5 to 7. The components of power conversion system 2 are arranged in consideration of the maintainability.

Fig. 5 is a plan view showing a specific arrangement example of power conversion system 2 shown in Fig. 1. In Fig. 5, wall surfaces 41 to 44 defining a housing chamber 40 are shown as cross sections.

Referring to Fig. 5, the plurality of submodules 20 (SUA, 5VA, 5WA) of upper arm 3A that forms power conversion device 2A shown in Fig. 1 and the plurality of submodules 20 (SUB, 5VB, 5WB) of upper arm 3B that forms power conversion device 2B shown in Fig. 1, and positive-side DC bus 14P that connects these submodules 20 are arranged in housing chamber 40. Similarly, the plurality of submodules 20 (6UA, 6VA, 6WA) of lower arm 4A that forms power conversion device 2A and the plurality of submodules 20 (6UB, 6VB, 6WB) of lower arm 4B that forms power conversion device 2B, and negative-side DC bus 14N that connects these submodules 20 are arranged in housing chamber 40. As described with reference to Figs. 3 and 4, the plurality of submodules 20 that form each arm are stacked like a tower.

More specifically, as shown in Fig. 5, each of positive-side DC bus 14P and negative-side DC bus 14N are arranged to extend in the Y direction in Fig. 5 in a plan view. However, positive-side DC bus 14P and negative-side DC bus 14N do not need to extend in the exactly the same direction. The plurality of submodules 20 (SUA, 5VA, 5WA) of upper arm 3A that forms power conversion device 2A and the plurality of submodules 20 (SUB, 5VB, 5WB) of upper arm 3B that forms power conversion device 2B are arranged opposite to each other with respect to positive-side DC bus 14P. Similarly, the plurality of submodules 20 (6UA, 6VA, 6WA) of lower arm 4A that forms power conversion device 2A and the plurality of submodules 20 (6UB, 6VB, 6WB) of lower arm 4B that forms power conversion device 2B are arranged opposite to each other with respect to negative-side DC bus 14N. In the above-described case, the plurality of submodules 20 of each arm that forms power conversion device 2A and the plurality of submodules 20 of the corresponding arm that forms power conversion device 2B are arranged side by side in the X direction crossing the Y direction.

The foregoing will be described from another point of view. The floor surface of housing chamber 40 includes a first region and a second region. In the case of the example shown in Fig. 5, the floor surface of housing chamber 40 is divided into a first region 49P and a second region 49N at a position indicated by a two-dot chain line 57. The plurality of submodules 20 (SUA, 5VA, 5WA) of upper arm 3A that forms power conversion device 2A, the plurality of submodules 20 (SUB, 5VB, 5WB) of upper arm 3B that forms power conversion device 2B, and positive-side DC bus 14P are arranged in first region 49P. The plurality of submodules 20 (6UA, 6VA, 6WA) of lower arm 4A that forms power conversion device 2A, the plurality of submodules 20 (6UB, 6VB, 6WB) of lower arm 4B that forms power conversion device 2B, and negative-side DC bus 14N are arranged in second region 49N.

Here, the plurality of submodules 20 (SUA, 5VA, 5WA) of upper arm 3A that forms power conversion device 2A are arranged between wall 41 and positive-side DC bus 14P, wall 41 defining housing chamber 40. The plurality of submodules 20 (SUB, 5VB, 5WB) of upper arm 3B that forms power conversion device 2B are arranged between wall 42 and positive-side DC bus 14P, wall 42 defining housing chamber 40 and facing wall 41. The plurality of submodules 20 (6UA, 6VA, 6WA) of lower arm 4A that forms power conversion device 2A are arranged between wall 41 and negative-side DC bus 14N. The plurality of submodules 20 (6UB, 6VB, 6WB) of lower arm 4B that forms power conversion device 2B are arranged between wall 42 and negative-side DC bus 14N.

A current transformer 46P for detecting a DC current, a voltage transformer 47P for detecting a DC voltage, and a DC lightning arrester 48P are connected to positive-side DC bus 14P. A current transformer 46N for detecting a DC current, a voltage transformer 47N for detecting a DC voltage, and a DC lightning arrester 48N are connected to negative-side DC bus 14N.

Air adjusted to be within a set temperature range and a set humidity range by an air conditioner 54 is supplied to housing chamber 40 through a duct 55. Furthermore, a dust-proof filter may be provided at an air outlet of air conditioner 54 to make a cleanliness inside housing chamber 40 higher than a cleanliness outside housing chamber 40. When the cleanliness inside housing chamber 40 is made higher as described above, an air pressure inside housing chamber 40 is set higher than an air pressure outside housing chamber 40.

Reactors 7UA, 7VA, 7WA, 8UA, 8VA, and 8WA that form power conversion device 2A and reactors 7UB, 7VB, 7WB, 8UB, 8VB, and 8WB that form power conversion device 2B are arranged opposite to each other with respect to housing chamber 40 outside housing chamber 40.

More specifically, reactors 7UA, 7VA, 7WA, 8UA, 8VA, and 8WA that form power conversion device 2A are arranged adjacent to the plurality of submodules 5UA, 5VA, 5WA, 6UA, 6VA, and 6WA, respectively, with wall 41 (that defines housing chamber 40) interposed therebetween. Reactors 7UA, 7VA, 7WA, 8UA, 8VA, and 8WA are connected to the plurality of submodules 5UA, 5VA, 5WA, 6UA, 6VA, and 6WA, respectively, via through bushings 51UA, 51VA, 51WA, 52UA, 52VA, and 52WA that pass through wall 41, respectively.

Similarly, reactors 7UB, 7VB, 7WB, 8UB, 8VB, and 8WB that form power conversion device 2B are arranged adjacent to the plurality of submodules 5UB, 5VB, 5WB, 6UB, 6VB, and 6WB, respectively, with wall 42 (that defines housing chamber 40 and faces wall 41) interposed therebetween. Reactors 7UB, 7VB, 7WB, 8UB, 8VB, and 8WB are connected to the plurality of submodules 5UB, 5VB, 5WB, 6UB, 6VB, and 6WB, respectively, via through bushings 51UB, 51V1, 51WB, 52UB, 52VB, and 52WB that pass through wall 42, respectively.

Reactors 7UA, 7VA, 7WA, 8UA, 8VA, and 8WA that form power conversion device 2A are connected to an AC bus 53A, and are connected to resistor for initial charging 10A and transformer 13A via AC bus 53A. Similarly, reactors 7UB, 7VB, 7WB, 8UB, 8VB, and 8WB that form power conversion device 2B are connected to an AC bus 53B, and are connected to resistor for initial charging 10B and transformer 13B via AC bus 53B. Each of AC buses 53A and 53B extends in the Y direction. The foregoing will be described from another point of view. AC bus 53A is arranged along wall 41 and the direction of extension of wall 41 outside housing chamber 40, and AC bus 53B is arranged along wall 42 and the direction of extension of wall 42 outside housing chamber 40. Reactors 7UA, 7VA, 7WA, 8UA, 8VA, and 8WA are arranged between AC bus 53A and housing chamber 40. Reactors 7UB, 7VB, 7WB, 8UB, 8VB, and 8WB are arranged between AC bus 53B and housing chamber 40.

In Fig. 5, the plurality of submodules 20 (SUA, 5VA, 5WA, 5UB, 5VB, 5WB) and positive-side DC bus 14P that are related to upper arms 3A and 3B, and the plurality of submodules 20 (6UA, 6VA, 6WA, 6UB, 6VB, 6WB) and negative-side DC bus 14N that are related to lower arms 4A and 4B are arranged to be separated in the Y direction. Therefore, housing chamber 40 may be divided in the Y direction by wall 57 extending in the X direction, such that the components related to upper arms 3A and 3B and the components related to lower arms 4A and 4B are housed in different chambers.

That is, a power conversion system according to a modification includes a first housing chamber and a second housing chamber. In the case of the example shown in Fig. 5, the first housing chamber corresponds to a portion having floor surface 49P, and is defined by wall 43, wall 57, a first wall (a portion of wall 41 that rises from floor surface 49P), and a second wall (a portion of wall 42 that rises from floor surface 49P). The first wall and the second wall face each other. The second housing chamber corresponds to a portion having floor surface 49N, and is defined by wall 44, wall 57, a third wall (a portion of wall 41 that rises from floor surface 49N), and a fourth wall (a portion of wall 42 that rises from floor surface 49N). The third wall is located in the direction of extension of the first wall, and the fourth wall is located in the direction of extension of the second wall. The third wall and the fourth wall face each other.

In the above-described case, the plurality of submodules 20 (SUA, 5VA, 5WA) of upper arm 3A that forms power conversion device 2A, the plurality of submodules 20 (SUB, 5VB, 5WB) of upper arm 3B that forms power conversion device 2B, and positive-side DC bus 14P are housed in the first housing chamber. The plurality of submodules 20 (6UA, 6VA, 6WA) of lower arm 4A that forms power conversion device 2A, the plurality of submodules 20 (6UB, 6VB, 6WB) of lower arm 4B that forms power conversion device 2B, and negative-side DC bus 14N are housed in the second housing chamber. The plurality of submodules 20 (SUA, 5VA, 5WA) of upper arm 3A are arranged between the first wall and positive-side DC bus 14P. The plurality of submodules 20 (SUB, 5VB, 5WB) of upper arm 3B are arranged between the second wall and positive-side DC bus 14P. The plurality of submodules 20 (6UA, 6VA, 6WA) of lower arm 4A are arranged between the third wall and negative-side DC bus 14N. The plurality of submodules 20 (6UB, 6VB, 6WB) of lower arm 4B are arranged between the fourth wall and negative-side DC bus 14N.

Reactors 7UA, 7VA and 7WA that form upper arm 3A of power conversion device 2A are arranged adjacent to the plurality of submodules 5UA, 5VA and 5WA, respectively, with the first wall interposed therebetween. Reactors 7UA, 7VA and 7WA are connected to the plurality of submodules 5UA, 5VA and 5WA, respectively, via through bushings 5 1UA, 51VA and 51WA that pass through the first wall, respectively.

Similarly, reactors 7UB, 7VB and 7WB that form upper arm 3B of power conversion device 2B are arranged adjacent to the plurality of submodules 5UB, 5VB and 5WB, respectively, with the second wall interposed therebetween. Reactors 7UB, 7VB and 7WB are connected to the plurality of submodules 5UB, 5VB and 5WB, respectively, via through bushings 51UB, 51VB and 51WB that pass through the second wall, respectively.

Reactors 8UA, 8VA and 8WA that form lower arm 4A of power conversion device 2A are arranged adjacent to the plurality of submodules 6UA, 6VA and 6WA, respectively, with the third wall interposed therebetween. Reactors 8UA, 8VA and 8WA are connected to the plurality of submodules 6UA, 6VA and 6WA, respectively, via through bushings 52UA, 52VA and 52WA that pass through the third wall, respectively.

Reactors 8UB, 8VB and 8WB that form lower arm 4B of power conversion device 2B are arranged adjacent to the plurality of submodules 6UB, 6VB and 6WB, respectively, with the fourth wall interposed therebetween. Reactors 8UB, 8VB and 8WB are connected to the plurality of submodules 6UB, 6VB and 6WB, respectively, via through bushings 52UB, 52VB and 52WB that pass through the fourth wall, respectively.

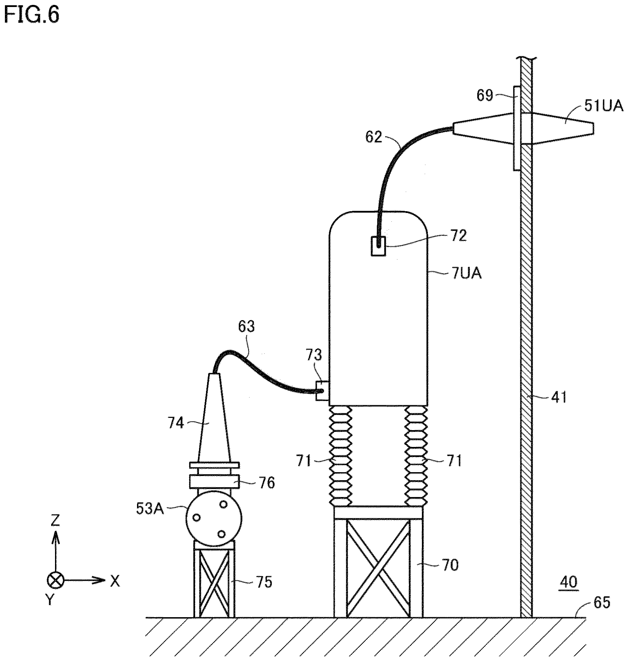

Next, a more detailed arrangement of reactor 7UA for the U-phase upper arm that forms power conversion device 2A will be described with reference to Fig. 6. The same applies as well to the reactors for the other phases, and power conversion device 2B.

Fig. 6 is a side view of a portion of reactor 7UA of U-phase upper arm 3UA shown in Fig. 5. In Fig. 6, wall surface 41 defining housing chamber 40, the floor portion, and AC bus 53A are shown as cross sections.

As shown in Fig. 6, reactor 7UA is supported by an insulator-equipped pillar 71 attached to a stand 70 on a floor surface 65. A first terminal 72 of reactor 7UA is connected to through bushing 51UA via a wire 62 (e.g., an aluminum stranded wire). Through bushing 51UA is fixed to wall 41 by a flange 69. A second terminal 73 of reactor 7UA is connected to AC bus 53A via a wire 63 and a bushing 74. AC bus 53A is, for example, a gas-tight bus. AC bus 53A is supported by a stand 75. A current transformer 76 for detecting an AC current (arm current) is provided between bushing 74 and AC bus 53A.

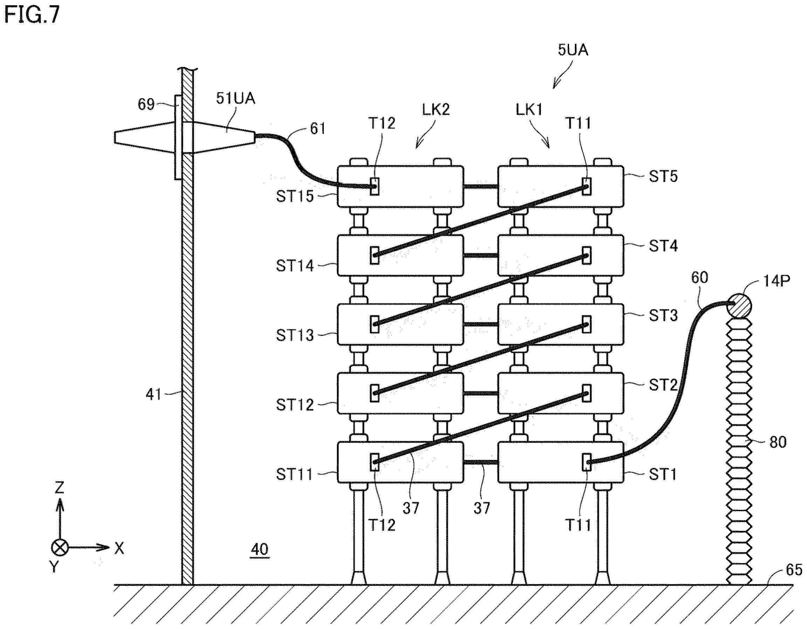

Next, a more detailed arrangement of the plurality of submodules 20 (SUA) for U-phase upper arm 3A that forms power conversion device 2A and positive-side DC bus 14P will be described with reference to Fig. 7. The same applies as well to the upper arms for the other phases, the lower arms, and power conversion device 2B.

Fig. 7 is a side view of a portion of the plurality of submodules 20 (SUA) and positive-side DC bus 14P shown in Fig. 5. In Fig. 7, wall surface 41 defining housing chamber 40, the floor portion, and positive-side DC bus 14P are shown as cross sections.

As shown in Fig. 7, positive-side DC bus 14P is supported on floor surface 65 by an insulator-equipped pillar 80. As described with reference to Figs. 3 and 4, the plurality of submodules 5UA are stacked like a tower. In racks LK1 and LK2, terminal T11 of stage ST1 having the highest potential is connected to positive-side DC bus 14P via a wire 60 (e.g., an aluminum stranded wire). In racks LK1 and LK2, terminal T12 of stage S15 having the lowest potential is connected to through bushing 51UA via a wire 61 (e.g., an aluminum stranded wire).

Through bushing 51UA is attached to wall 41 such that a lowermost end of through bushing 51UA (i.e., a lowermost end of flange 69) is located at a position higher than at least one of uppermost ends of racks LK1 and LK2 and an uppermost end of reactor 7UA. Thus, through bushing 51UA can be pulled out from wall 41 at the time of maintenance and inspection of through bushing 51UA. The above-described arrangement of the through bushing applies as well to the other phases and the lower arms.

### [Effects]

As described above, in power conversion system 2 according to the embodiment above, DC buses 14P and 14N and the plurality of submodules 20, which are greatly affected by a fault and have a relatively high frequency of maintenance, are arranged in clean housing chamber 40. In contrast, reactors 7A, 7B, 8A, and 8B, which are susceptible to contamination by an insulating oil, are arranged outside housing chamber 40. Thus, it becomes easier to perform maintenance of DC buses 14P and 14N and the plurality of submodules 20 that are important parts having a relatively high frequency of maintenance.

It should be understood that the embodiment disclosed herein is illustrative and non-restrictive in every respect. The scope of the present application is defined by the terms of the claims, rather than the description above, and is intended to include any modifications within the scope and meaning equivalent to the terms of the claims.

### REFERENCE SIGNS LIST

1A first AC power system; 1B second AC power system; 2 power conversion system; 2A first power conversion device; 2B second power conversion device; 3 upper arm; 4 lower arm; 5, 6, 20 submodule; 7, 8 reactor; 9 AC terminal; 10A, 10B resistor for initial charging; 13A, 13B transformer; 14N negative-side DC bus; 14P positive-side DC bus; 40 housing chamber; 41, 42 wall; 51, 52 through bushing; 53 AC bus; 54 air conditioner; 55 duct; 65 floor surface; LK1, LK2 rack; T1, T2 input/output terminal; T11 positive-side terminal; T12 negative-side terminal.

## Claims

1. A power conversion system that performs power conversion between a first AC power system and a second AC power system, the power conversion system comprising:
a positive-side DC bus and a negative-side DC bus;
a plurality of first upper arms connected between respective phases of the first AC power system and the positive-side DC bus;
a plurality of first lower arms connected between the respective phases of the first AC power system and the negative-side DC bus;
a plurality of second upper arms connected between respective phases of the second AC power system and the positive-side DC bus; and
a plurality of second lower arms connected between the respective phases of the second AC power system and the negative-side DC bus, wherein
each of the plurality of first upper arms, the plurality of first lower arms, the plurality of second upper arms, and the plurality of second lower arms includes:
a plurality of submodules cascade-connected to each other, each of the plurality of submodules serving as a unit converter that converts between AC power and DC power; and
a reactor connected in series to the plurality of submodules,
in each of the plurality of first upper arms and each of the plurality of second upper arms, the plurality of submodules are connected between the reactor and the positive-side DC bus,
in each of the plurality of first lower arms and each of the plurality of second lower arms, the plurality of submodules are connected between the reactor and the negative-side DC bus,
the power conversion system further comprises at least one housing chamber that houses the plurality of submodules of each of the plurality of first upper arms, the plurality of submodules of each of the plurality of first lower arms, the plurality of submodules of each of the plurality of second upper arms, the plurality of submodules of each of the plurality of second lower arms, the positive-side DC bus, and the negative-side DC bus, and
the reactor of each of the plurality of first upper arms, the reactor of each of the plurality of first lower arms, the reactor of each of the plurality of second upper arms, and the reactor of each of the plurality of second lower arms are provided outside the at least one housing chamber.

2. The power conversion system according to claim 1, further comprising
an air conditioner for controlling a temperature, a humidity and a cleanliness of the at least one housing chamber to be within a set range.

3. The power conversion system according to claim 1 or 2, wherein
each of the positive-side DC bus and the negative-side DC bus is arranged to extend in one direction in a plan view,
the plurality of submodules of each of the plurality of first upper arms and the plurality of submodules of each of the plurality of second upper arms are arranged opposite to each other with respect to the positive-side DC bus in a plan view, and
the plurality of submodules of each of the plurality of first lower arms and the plurality of submodules of each of the plurality of second lower arms are arranged opposite to each other with respect to the negative-side DC bus in a plan view.

4. The power conversion system according to claim 3, wherein
the at least one housing chamber is a single housing chamber,
a floor surface of the single housing chamber includes a first region and a second region different from the first region,
the plurality of submodules of each of the plurality of first upper arms, the plurality of submodules of each of the plurality of second upper arms, and the positive-side DC bus are arranged in the first region,
the plurality of submodules of each of the plurality of first lower arms, the plurality of submodules of each of the plurality of second lower arms, and the negative-side DC bus are arranged in the second region,
the plurality of submodules of each of the plurality of first upper arms are arranged between a first wall and the positive-side DC bus, the first wall defining the single housing chamber,
the plurality of submodules of each of the plurality of second upper arms are arranged between a second wall and the positive-side DC bus, the second wall defining the single housing chamber and facing the first wall,
the plurality of submodules of each of the plurality of first lower arms are arranged between the first wall and the negative-side DC bus, and
the plurality of submodules of each of the plurality of second lower arms are arranged between the second wall and the negative-side DC bus.

5. The power conversion system according to claim 4, wherein
the plurality of submodules and the reactor that form one of the plurality of first upper arms are arranged adjacent to each other with the first wall interposed therebetween, and are connected to each other via a first through bushing passing through the first wall,
the plurality of submodules and the reactor that form one of the plurality of second upper arms are arranged adjacent to each other with the second wall interposed therebetween, and are connected to each other via a second through bushing passing through the second wall,
the plurality of submodules and the reactor that form one of the plurality of first lower arms are arranged adjacent to each other with the first wall interposed therebetween, and are connected to each other via a third through bushing passing through the first wall, and
the plurality of submodules and the reactor that form one of the plurality of second lower arms are arranged adjacent to each other with the second wall interposed therebetween, and are connected to each other via a fourth through bushing passing through the second wall.

6. The power conversion system according to claim 3, wherein
the at least one housing chamber includes a first housing chamber and a second housing chamber,
the plurality of submodules of each of the plurality of first upper arms, the plurality of submodules of each of the plurality of second upper arms, and the positive-side DC bus are housed in the first housing chamber,
the plurality of submodules of each of the plurality of first lower arms, the plurality of submodules of each of the plurality of second lower arms, and the negative-side DC bus are housed in the second housing chamber,
the plurality of submodules of each of the plurality of first upper arms are arranged between a first wall and the positive-side DC bus, the first wall defining the first housing chamber,
the plurality of submodules of each of the plurality of second upper arms are arranged between a second wall and the positive-side DC bus, the second wall defining the first housing chamber and facing the first wall,
the plurality of submodules of each of the plurality of first lower arms are arranged between a third wall and the negative-side DC bus, the third wall defining the second housing chamber and being located in a direction of extension of the first wall, and
the plurality of submodules of each of the plurality of second lower arms are arranged between a fourth wall and the negative-side DC bus, the fourth wall defining the second housing chamber, being located in a direction of extension of the second wall, and facing the third wall.

7. The power conversion system according to claim 6, wherein
the plurality of submodules and the reactor that form one of the plurality of first upper arms are arranged adjacent to each other with the first wall interposed therebetween, and are connected to each other via a first through bushing passing through the first wall,
the plurality of submodules and the reactor that form one of the plurality of second upper arms are arranged adjacent to each other with the second wall interposed therebetween, and are connected to each other via a second through bushing passing through the second wall,
the plurality of submodules and the reactor that form one of the plurality of first lower arms are arranged adjacent to each other with the third wall interposed therebetween, and are connected to each other via a third through bushing passing through the third wall, and
the plurality of submodules and the reactor that form one of the plurality of second lower arms are arranged adjacent to each other with the fourth wall interposed therebetween, and are connected to each other via a fourth through bushing passing through the fourth wall.

8. The power conversion system according to claim 5 or 7, wherein
a lower end of the first through bushing is higher than at least one of an upper end of the reactor of a corresponding one of the plurality of first upper arms and an upper end of a rack that houses the plurality of submodules of the corresponding one of the plurality of first upper arms,
a lower end of the second through bushing is higher than at least one of an upper end of the reactor of a corresponding one of the plurality of second upper arms and an upper end of a rack that houses the plurality of submodules of the corresponding one of the plurality of second upper arms,
a lower end of the third through bushing is higher than at least one of an upper end of the reactor of a corresponding one of the plurality of first lower arms and an upper end of a rack that houses the plurality of submodules of the corresponding one of the plurality of first lower arms, and
a lower end of the fourth through bushing is higher than at least one of an upper end of the reactor of a corresponding one of the plurality of second lower arms and an upper end of a rack that houses the plurality of submodules of the corresponding one of the plurality of second lower arms.

9. The power conversion system according to any one of claims 5, 7 and 8, wherein
an AC bus of the first AC power system is arranged along the first wall and a direction of extension of the first wall outside the at least one housing chamber, and is connected to the reactor of each of the plurality of first upper arms and the reactor of each of the plurality of first lower arms, and
an AC bus of the second AC power system is arranged along the second wall and a direction of extension of the second wall outside the at least one housing chamber, and is connected to the reactor of each of the plurality of second upper arms and the reactor of each of the plurality of second lower arms.
